(19) Europäisches Patentamt / European Patent Office / Office européen des brevets

(11) **EP 1 393 440 B1**

(12) **EUROPÄISCHE PATENTSCHRIFT**

(45) Veröffentlichungstag und Bekanntmachung des Hinweises auf die Patenterteilung:
**24.06.2009 Patentblatt 2009/26**

(21) Anmeldenummer: **02771632.3**

(22) Anmeldetag: **29.04.2002**

(51) Int Cl.:
**H03H 9/17** (2006.01)

(86) Internationale Anmeldenummer:
**PCT/EP2002/004717**

(87) Internationale Veröffentlichungsnummer:
**WO 2002/095939 (28.11.2002 Gazette 2002/48)**

(54) **PIEZOELEKTRISCHE RESONATORVORRICHTUNG MIT VERSTIMMUNGSSCHICHTFOLGE**

PIEZOELECTRIC RESONATOR DEVICE WITH A DETUNING LAYER SEQUENCE

DISPOSITIF A RESONATEUR PIEZO-ELECTRIQUE POURVU D'UNE SERIE DE COUCHES DE DESACCORD

(84) Benannte Vertragsstaaten:
**DE FR GB IT**

(30) Priorität: **18.05.2001 DE 10124349**

(43) Veröffentlichungstag der Anmeldung:
**03.03.2004 Patentblatt 2004/10**

(73) Patentinhaber: **Avago Technologies Wireless IP (Singapore) Pte. Ltd.**
**Singapore 768923 (SG)**

(72) Erfinder:
• **AIGNER, Robert**
  **81675 München (DE)**

• **ELBRECHT, Lueder**
  **81825 München (DE)**
• **MARKSTEINER, Stephan**
  **85640 Putzbrunn (DE)**
• **NESSLER, Winfried**
  **81739 München (DE)**

(74) Vertreter: **Dilg, Andreas et al**
**Dilg, Haeusler, Schindelmann (DHS)**
**Patentanwaltsgesellschaft mbH**
**Leonrodstrasse 58**
**80636 München (DE)**

(56) Entgegenhaltungen:
**EP-A- 0 880 227          WO-A-99/10938**
**US-A- 5 894 647**

## Beschreibung

Die vorliegende Erfindung bezieht sich auf piezoelektrische Resonatorvorrichtungen und insbesondere auf eine piezoelektrische Dünnschicht-Resonatorvorrichtung mit einer Verstimmungsschichtfolge, die mehrere Schichten mit unterschiedlicher akustischer Impedanz aufweist.

Piezoelektrische Resonatoren bzw. akustische Volumenwelleresonatoren (BAW-Resonatoren; BAW = Bulk-Acoustic-Wave) finden als Filter in der Hochfrequenztechnik vielfältige Anwendung. Bei den weit verbreiteten Schaltungen vom Leiter-Typ (Ladder-Typ) oder vom Lattice- bzw. Balanced-Typ werden mehrere piezoelektrische Resonatoren in Serie zwischen einen Eingang und einen Ausgang geschaltet. Bei Schaltungen vom Ladder-Typ werden Knoten zwischen benachbarten Resonatoren über einen weiteren BAW-Resonator mit Masse verbunden (Nebenschluß-Resonator). Zusätzlich können parallel zum Eingang und/oder Ausgang des Filters weitere Nebenschluß-Resonatoren vorgesehen sein. Der oder die Nebenschluß-Resonatoren weisen eine Resonanzfrequenz auf, die typischerweise um 2% bis 3% niedriger ist als die Resonanzfrequenzen der in Serie zwischen Eingang und Ausgang geschalteten Resonatoren. Diese leichte Verstimmung der Resonatorgruppen gegeneinander entspricht etwa 50% bis 80% der Filter-Bandbreite.

Typischerweise werden alle in der beschriebenen Leiter-Schaltung enthaltenen Resonatoren auf einem gemeinsamen Substrat gefertigt und durch Leiterbahnen miteinander verschaltet. Ein praktisch identischer Aufbau aller Resonatoren auf einem Substrat hat ohne weitere Maßnahmen praktisch identische Resonanzfrequenzen der Resonatoren zur Folge.

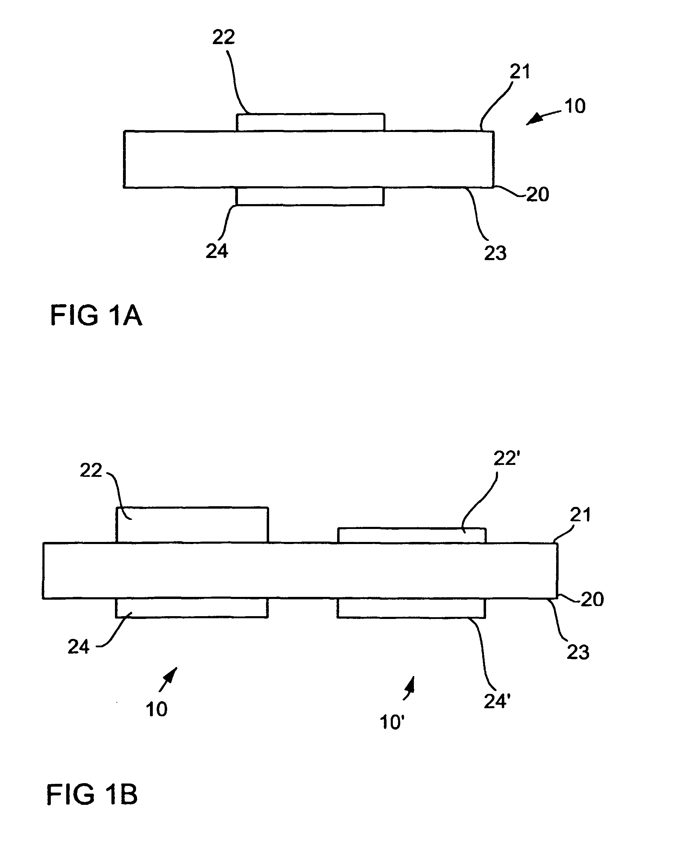

Anhand der Figur 1A wird nachfolgend ein Beispiel für den Aufbau eines bekannten BAW-Resonators erläutert. Der BAW-Resonator 10 umfasst eine piezoelektrische Schicht 20, z.B. aus AlN, ZnO, PZT. Die piezoelektrische Schicht 20 weist an einer ersten Oberfläche 21 eine erste Elektrode 22 und an einer zweiten Oberfläche 23, die der ersten Oberfläche 21 gegenüberliegt, eine zweite Elektrode 24 auf, wobei die Elektroden 22, 24 beispielsweise Aluminium, Wolfram, Molybdän oder Kombinationen dieser Materialien aufweisen. Die Resonanzfrequenz des Resonators 10 ist durch die physikalischen Eigenschaften, z.B. Dicke, Schallgeschwindigkeit, akustische Impedanz, der verwendeten Materialien festgelegt.

Der piezoelektrische Resonator 10 ist auf einem Substrat (nicht gezeigt) angeordnet, wobei eine akustische Isolation des piezoelektrischen Resonators 10 von dem Substrat erforderlich ist. Diese akustische Isolation kann z.B. durch einen akustischen Reflektor (nicht gezeigt), der zwischen dem Resonator und dem Substrat angeordnet ist, erreicht werden. Der Reflektor weist eine Mehrzahl von Schichten aus Materialien mit unterschiedlichen mechanische Eigenschaften auf. Die Dicke jeder Schicht entspricht näherungsweise einem Viertel der Wellenlänge einer Welle, die sich in den Schichten ausbreitet, oder einem ungeradzahligen Vielfachen davon. Die akustische Isolation des Resonators von dem Substrat kann auch durch andere bekannte Techniken erreicht werden, z.B. durch einen Hohlraum zwischen dem Substrat und dem Resonator. Alternativ kann der Resonator auch durch andere Konstruktionen gehalten werden, so dass in diesen Fällen kein Substrat vorgesehen ist.

Fig. 1B zeigt eine Anordnung mit einem ersten piezoelektrischen Resonator 10 und einem zweiten piezoelektrischen Resonator 10'. Der zweite piezoelektrische Resonator ist durch die zwei Elektroden 22' und 24' gebildet, die auf der ersten Oberfläche 21 bzw. auf der zweiten Oberfläche 23 der piezoelektrischen Schicht 20 gebildet sind. Die Resonatoren sind verschaltet, um ein Filter zu bilden, wobei der erste Resonator 10 den oben beschriebenen Nebenschluß-Resonator bildet.

Um die Resonanzfrequenz des ersten Resonators 10 gegenüber der Resonanzfrequenz des zweiten Resonators 10' zu verschieben bzw. zu verstimmen, können verschiedene, räumlich auf den Resonator 10 begrenzte Maßnahmen ergriffen werden. Eine Veränderung der Dicke der ersten Elektrode 22 des piezoelektrischen Resonators 10, wie es in Fig. 1B gezeigt ist, hat eine Veränderung der Resonanzfrequenz des Resonators zur Folge. Um den Resonator 10 zu verstimmen, wird deshalb beispielsweise in einem zusätzlichen Schritt die Dicke der ersten Elektrode 22 durch Aufbringen einer dünnen zusätzlichen Metallschicht oder durch Dünnen der ersten Elektrode 22, z. B. durch Ätzen einer Teilschicht der Elektrode, verändert.

Typische Anwendungen, z.B. im Mobilfunk, erfordern eine Frequenzgenauigkeit der in einem Filter verwendeten Resonatoren im Bereich deutlich unter 1%, z.B. 0,25% bei GSM 1800. Diese Anforderungen sind bei der Herstellung der oben beschriebenen Resonatoren nur sehr schwer zu erfüllen, so dass weitere Schritte zur Feineinstellung der Resonanzfrequenz ergriffen werden müssen.

Nach erfolgter Verstimmung wird zur Feineinstellung der Frequenz der Resonatoren 10, 10' beispielsweise die erste Elektrode 22, 22' herangezogen. Die Feineinstellung wird durchgeführt, indem die Dicke der Elektroden verändert wird oder eine zusätzliche Schicht mit festgelegter Dicke auf den Elektroden abgeschieden wird. Dies erfolgt sowohl bei dem verstimmten Resonator 10 als auch bei dem unverstimmten Resonator 10'. Die Veränderung der Dicke der ersten Elektroden 22, 22' hat jedoch den Nachteil einer unerwünschten Veränderung der Verstimmung des ersten Resonators 10.

Da die Verstimmung das Verhalten eines durch die Resonatoren 10 und 10' gebildeten Filters jedoch stark beeinflusst, darf das Trimmen keine starke Veränderung der Verstimmung hervorrufen, so dass ein Umfang des "Trimmens" (Frequenzfeineinstellens), das auf die Resonatoren 10, 10' angewendet werden kann, stark beschränkt ist.

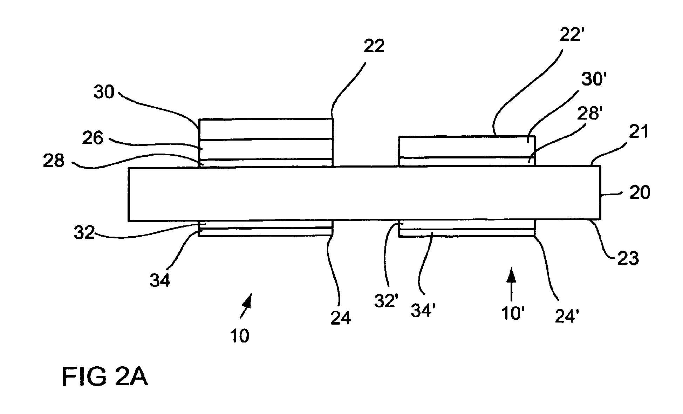

Eine bekannte Möglichkeit zur Verstimmung eines Resonators besteht darin, dem zu verstimmenden Resonator 10 eine Verstimmungsschicht aus einem Material mit einer hohen akustischen Impedanz oder einer niedrigen akustischen Impedanz zuzuordnen. Anhand der Figuren 2A bis 2C wird diese Vorgehensweise und deren Auswirkungen näher erläutert.

In Fig. 2A ist eine Resonatorvorrichtung dargestellt, bei der der verstimmte Resonator 10 eine Verstimmungsschicht 26 aufweist. Bei der in Fig. 2A gezeigten Resonatorvorrichtung sind die Elektroden 22, 22', 24, 24' der Resonatoren 10, 10' mehrschichtig ausgebildet. Die erste Elektrode 22 des ersten Resonators 10 umfasst eine erste Schicht 28, z.B. aus Wolfram, und eine zweite Schicht 30, z.B. aus Aluminium. Die Verstimmungsschicht 26 ist zwischen den Schichten 28 und 30 der ersten Elektrode 22 angeordnet. Die erste Elektrode 22' des zweiten Resonators 10' umfasst eine erste Schicht 28', z.B. aus Wolfram, und eine zweite Schicht 30', z.B. aus Aluminium. Die zweite Elektrode 24 des ersten Resonators 10 umfasst eine erste Schicht 32, z.B. aus Wolfram, und eine zweite Schicht 34, z.B. aus Aluminium. Die zweite Elektrode 24' des zweiten Resonators 10' umfasst eine erste Schicht 32', z.B. aus Wolfram, und eine zweite Schicht 34', z.B. aus Aluminium. Die Schichtdicken der Elektroden sind im wesentlichen gleich. Abgesehen von der Verstimmungsschicht 26 sind die Resonatoren 10 und 10' im wesentlichen gleich.

Wird eine Verstimmungsschicht 26 mit niedriger akustischer Impedanz verwendet, so besteht die Verstimmungsschicht z.B. aus Aluminium, das eine niedrige akustische Impedanz aufweist. Alternativ kann auch eine Schicht aus Silizium-Oxid verwendet werden. In diesem Fall ist eine entsprechende Kontaktierung der zwei Schichten der Elektrode 22, z.B. über Durchgangslöcher, erforderlich. Zur Feineinstellung der Resonanzfrequenz wird (bei konstanter Verstimmungsschicht) die Dicke der Aluminiumschicht 30, 30' der ersten Elektroden 22, 22' jedes Resonators verändert. Eine Änderung der Dicke der Aluminiumschicht 30 der ersten Elektrode 22 beeinflusst ferner die Verstimmung des verstimmten Resonators 10 gegenüber dem unverstimmten Resonator 10'.

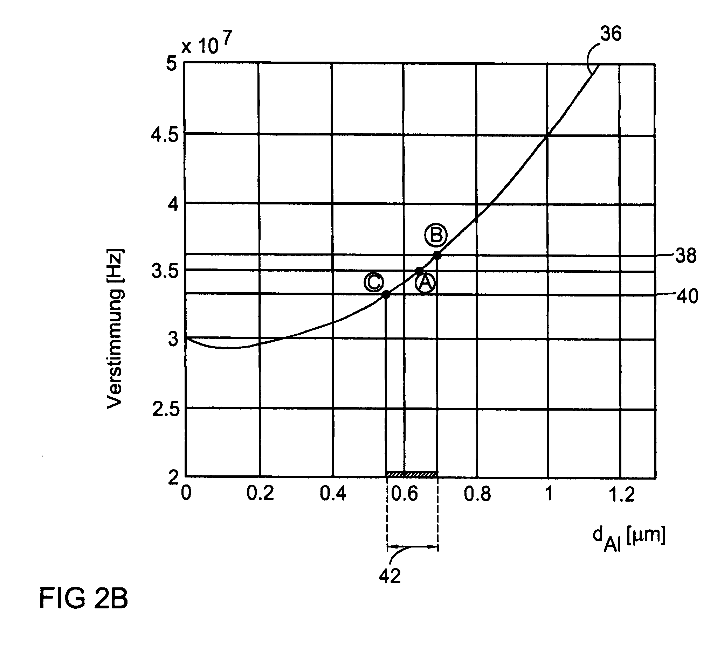

Fig. 2B zeigt eine schematische Darstellung der Abhängigkeit der Verstimmung des piezoelektrischen Resonators 10 aus Fig. 2A von der Dicke $d_{Al}$ der Aluminiumschicht 30 der ersten Elektrode 22 des piezoelektrischen Resonators 10. In Fig. 2B ist die Verstimmung über der Dicke $d_{Al}$ der Aluminiumschicht der ersten Elektrode aufgetragen, und die Kurve 36 zeigt den Betrag an Verstimmung als Funktion der Dicke $d_{Al}$ bei einer konstanten Dicke der Verstimmungsschicht 26. Die Verstimmung des piezoelektrischen Resonator 10 mit der Verstimmungsschicht gegenüber dem piezoelektrischen Resonator 10' ohne Verstimmungsschicht mit sonst gleichen Eigenschaften beträgt z. B. 35 MHz bei einer Dicke der Aluminiumschicht der ersten Elektrode 22 von 0,66 $\mu$m, wie es in Fig. 2B durch den Punkt A angedeutet ist.

Eine Vergrößerung der Dicke $d_{Al}$ führt zu einer Erhöhung der Verstimmung, und eine Reduzierung der Dicke $d_{Al}$ führt zu einer Reduzierung der Verstimmung. Durch die Linien 38 und 40 ist ein noch akzeptabler Toleranzbereich dargestellt, in dem eine Abweichung von der Sollverstimmung, die durch eine zusätzliche Frequenzkorrektur (Trimmen) erreicht wird, liegen darf. Innerhalb dieses Toleranzbereiches sind Auswirkungen der Abweichung der Verstimmung von den 35 MHz aufgrund der Frequenzkorrektur auf die Eigenschaften eines Filters, das den so verstimmten Resonator umfasst, noch vernachlässigbar oder zumindest hinnehmbar.

Durch die Schnittpunkte B und C der Kurve 36 mit den Linien 38 bzw. 40 ist ein Dickenbereich 42 festgelegt, innerhalb dessen die Dicke $d_{Al}$ der Aluminiumschicht der ersten Elektroden 22, 22' geändert werden kann. Bedingt durch die große Steigung der Kurve 36 ist nur ein kleiner Bereich an Dicken von etwa 0,55 $\mu$m bis etwa 0,7 $\mu$m verfügbar. In diesem Bereich kann die Dicke der Aluminiumschicht der ersten Elektroden 22, 22' geändert werden, ohne dass dies zu einer Veränderung der Verstimmung außerhalb des Toleranzbereiches führen würde. Nutzt man den in Fig. 2B gezeigten Toleranzbereich voll aus, läuft also entlang der Kurve 36 vom Punkt B über Punkt A zu Punkt C, so ist durch die Änderung der Dicke $d_{Al}$ eine Frequenzkorrektur (Frequenzverschiebung) von ±10 MHz bei einer Resonanzfrequenz von 900 MHz des Resonators erreichbar. Mit anderen Worten wird eine Resonanzfrequenz des Resonators 20 von ±10 MHz zu einer Änderung der Verstimmung führen, die noch im Toleranzbereich liegt.

Da bei typischen Anwendungen, z.B. im Mobilfunkbereich, Korrekturen von etwa ±3% der Resonanzfrequenz erforderlich sind, z.B. etwa ±30MHz bei einer Resonanzfrequenz von 900MHz, kann durch das obige Verfahren nur ein geringer Anteil der gefertigten Filteranordnungen korrigiert werden, nämlich der Anteil, der frequenzmäßig um ±10MHz von der erwünschten Frequenz abweicht. Alle anderen Filter mit einer größeren Abweichung können nicht korrigiert werden.

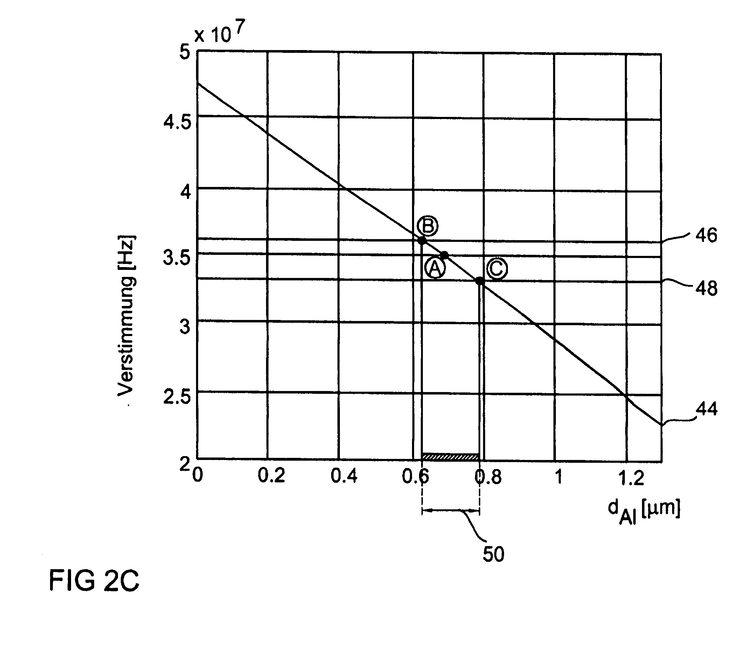

Fig. 2C zeigt das Verhalten einer Anordnung, bei der der verstimmte Resonator 10 zur Verstimmung eine Verstimmungsschicht 26 aus Molybdän, das eine hohe akustische Impedanz aufweist, umfasst. Alternativ können auch andere Materialien mit eine hohen akustischen Impedanz verwendet werden, z.B. Wolfram, Platin oder Tantaloxid ($Ta_2O_5$).

In Fig. 2C ist die Verstimmung über der Dicke $d_{Al}$ der Aluminiumschicht 30 der ersten Elektrode 22 aufgetragen, und die Kurve 44 zeigt den Betrag der Verstimmung als Funktion der Dicke $d_{Al}$ bei einer konstanten Dicke der Verstimmungsschicht. Bei einer Dicke der Aluminiumschicht von etwa 0,66 $\mu$m, wie es in Fig. 2C durch den Punkt A dargestellt ist, beträgt die Verstimmung der piezoelektrischen Resonatorvorrichtung 10 gegenüber der piezoelektrischen Resonatorvorrichtung 10' ohne Verstimmungsschicht mit sonst identischen Eigenschaften etwa 35 MHz. Anders als bei dem anhand der Fig.

2B erörterten Beispiel hat bei einer Verstimmungsschicht mit hoher akustischer Impedanz eine Vergrößerung der Dicke $d_{Al}$ der Elektrode eine umgekehrte Wirkung, d. h. die Verstimmung nimmt ab. Umgekehrt nimmt die Verstimmung der piezoelektrischen Resonatorvorrichtung zu, wenn die Dicke $d_{Al}$ der Elektroden verringert wird.

Ähnlich wie in Fig. 2B wird auch in Fig. 2C durch die Linien 46 und 48 ein noch akzeptabler Toleranzbereich dargestellt, in dem eine Abweichung von der Sollverstimmung, die aufgrund einer zusätzlichen Frequenzkorrektur (Trimmen) der Resonanzfrequenz des Resonators hervorgerufen wird, liegen darf. Innerhalb dieses Toleranzbereiches liegende Abweichungen der Verstimmung und die damit verbundene Änderung der Filtereigenschaften sind noch vernachlässigbar oder zumindest hinnehmbar. Durch die Schnittpunkte B und C der Kurve 44 mit den Linien 46 bzw. 48 ist ein Dickenbereich 50 festgelegt, innerhalb dessen die Dicke $d_{Al}$ der Aluminiumschicht der ersten Elektroden geändert werden kann. Bedingt durch die große Steigung der Kurve 44 ist nur ein kleiner Bereich an Dicken von etwa 0,62 μm bis etwa 0,78 μm verfügbar. In diesem Bereich kann die Dicke der Aluminiumschicht der ersten Elektroden geändert werden, ohne dass die dadurch bewirkte Frequenzkorrektur zu einer Veränderung der Verstimmung außerhalb des Toleranzbereiches führen würde.

Allerdings ist auch hier der Trimmbereich, aus denselben Gründen wie bei dem Beispiel aus Fig. 2B, beschränkt; bei dem in Fig. 2C gezeigten Beispiel auf 20 MHz bei einer Resonanzfrequenz von 900 MHz.

Die WO 99/10938 A betrifft einen piezoelektrischen Resonator, welcher eine Opferschicht zur Einstellung einer Frequenz desselben umfaßt. Der piezoelektrische Resonator hat eine piezoelektrische Schicht, auf deren zwei Hauptoberflächen Elektroden angeordnet sind. Auf einer der Elektroden ist die Opferschicht angeordnet, beispielsweise eine Oxidschicht, wobei vorzugsweise zwischen der Opferschicht und der Elektrode eine Diffusionsbarriere angeordnet ist. Die Opferschicht wird gedünnt, um eine Resonanzfrequenz des Gesamtelements auf einen erwünschten Wert anzuheben, um so die Zielresonanzfrequenz des Gesamtelements einzustellen.

Die US-A-5,894,647 beschreibt ein Verfahren zum Herstellen piezoelektrischer Resonatoren auf einem Substrat derart, daß eine Resonanzfrequenz eines Resonators gegenüber den Resonanzfrequenzen der übrigen Resonatoren um einen kleinen Betrag verschoben ist. Dies wird dadurch erreicht, daß der betroffene Resonator, dessen Resonanzfrequenz zu verschieben ist, mit einer dünnen zusätzlichen Schicht, beispielsweise durch Aufsputtern oder ähnliches, versehen wird, um so die Frequenz des zugeordneten Resonatorelements zu verschieben.

Die Aufgabe der vorliegenden Erfindung besteht darin, eine piezoelektrische Resonatorvorrichtung zu schaffen, deren Resonanzfrequenz über einen große Frequenzbereich trimmbar ist, ohne daß eine Verstimmung einen Toleranzbereich verläßt.

Diese Aufgabe wird durch eine Resonatorvorrichtung gemäß Anspruch 1 gelöst.

Der vorliegenden Erfindung liegt die Erkenntnis zugrunde, zum Verstimmen einer piezoelektrischen Resonatorvorrichtung eine Verstimmungsschichtfolge zu verwenden, die aus mindestens zwei Schichten mit unterschiedlichen mechanischen bzw. akustischen Eigenschaften besteht und die Resonanzfrequenz der piezoelektrischen Resonatorvorrichtung gegenüber der Resonanzfrequenz einer piezoelektrischen Resonatorvorrichtung ohne Verstimmungsschichtfolge mit sonst gleichen Eigenschaften verschiebt. Die erste Schicht hat eine hohe akustische Impedanz und die zweite Schicht hat eine niedrige akustische Impedanz. Gemäß der vorliegenden Erfindung wird der Trimmbereich gegenüber den im Stand der Technik bekannten Ansätzen vergrößert, ohne eine außerhalb eines Toleranzbereiches liegende Abweichung der Verstimmung zu bewirken.

Gemäß einem bevorzugten Ausführungsbeispiel der vorliegenden Erfindung ist die Schicht mit der niedrigen akustischen Impedanz Aluminium (Al), Siliziumdioxid ($SiO_2$) oder ein anderes Material mit einer niedrigen akustischen Impedanz. Die Schicht mit der hohen akustischen Impedanz kann Wolfram (W), Molybdän (Mo), Platin (Pt), Tantaloxid ($Ta_2O_5$) oder ein anderes Material mit einer hohen akustischen Impedanz aufweisen. Die Reihenfolge der Schichten in der Schichtfolge ist beliebig. Die Dicke der Schicht mit der hohen akustischen Impedanz liegt vorzugsweise in einem Bereich von 10nm bis 60nm, vorzugsweise von 20nm bis 60nm, die Dicke der Schicht mit der niedrigen akustischen Impedanz liegt in einem Bereich von 50nm bis 200nm, vorzugsweise von 100nm bis 200nm. Der erste piezoelektrische Resonator ist vorzugsweise ein piezoelektrischer Resonator mit einer piezoelektrischen Schicht, die an einer ersten Oberfläche eine erste Elektrode und an einer zweiten Oberfläche eine zweite Elektrode aufweist.

Gemäß einem weiteren bevorzugten Ausführungsbeispiel ist ein weiterer piezoelektrischen Resonator vorgesehen, und die Verstimmungsschichtfolge ist nur im Bereich des ersten piezoelektrischen Resonators angeordnet. Die Resonanzfrequenzen des piezoelektrischen Resonators und des weiteren piezoelektrischen Resonators unterscheiden sich vorzugsweise um 2% bis 3%. Beide piezoelektrische Resonatoren können durch Elektroden gebildet sein, die auf gegenüberliegenden Oberflächen einer piezoelektrischen Schicht angeordnet sind. Der weitere piezoelektrische Resonator ist zwischen einen ersten Knoten und einen zweiten Knoten geschaltet, und der verstimmte piezoelektrische Resonator ist zwischen den zweiten Knoten und Masse geschaltet, um ein Filter zu schaffen.

Die Resonanzfrequenzen der piezoelektrischen Resonatoren sind durch Ändern der Dicke einer Elektrode der Resonatoren einstellbar. Die Dicke der Elektrode kann geändert werden, indem auf die Elektrode eine zusätzliche Schicht aufgebracht wird (beispielsweise durch Aufsputtern), oder indem die Elektrode gedünnt wird (beispielsweise durch Ätzen).

Die akustischen Impedanzen der Schichten der Verstimmungsschichtfolge unterscheiden sich vorzugsweise etwa um den Faktor zwei voneinander, d.h. die Impedanz der Schicht mit hoher akustischer Impedanz ist etwa doppelt so groß wie die Impedanz der Schicht mit niedriger akustischer Impedanz. Die Impedanz der Schicht mit hoher akustischer Impedanz ist vorzugsweise größer als etwa $60 \times 10^6 \; \frac{kg}{s \cdot m^2}$ und liegt bei einem Ausführungsbeispiel zwischen etwa $60 \times 10^6 \; \frac{kg}{s \cdot m^2}$ und etwa $100 \times 10^6 \; \frac{kg}{s \cdot m^2}$. Die Impedanz der Schicht mit niedriger akustischer Impedanz ist vorzugsweise kleiner als etwa $30 \times 10^6 \; \frac{kg}{s \cdot m^2}$ und liegt gemäß einem Ausführungsbeispiel zwischen etwa $10 \times 10^6 \; \frac{kg}{s \cdot m^2}$ und etwa $30 \times 10^6 \; \frac{kg}{s \cdot m^2}$.

Bevorzugte Ausführungsbeispiele der vorliegenden Erfindung werden nachfolgend Bezug nehmend auf die beiliegenden Zeichnungen näher erläutert. Es zeigen:

Fig. 1A eine schematische Darstellung einer piezoelektrischen Resonatorvorrichtung gemäß dem Stand der Technik;

Fig. 1B eine schematische Darstellung einer piezoelektrischen Resonatorvorrichtung gemäß dem Stand der Technik bestehend aus einem verstimmten und einem unverstimmten Resonator;

Fig. 2A eine schematische Darstellung einer piezoelektrischen Resonatorvorrichtung gemäß dem Stand der Technik bestehend aus einem verstimmten Resonator mit einer Verstimmungsschicht und einem unverstimmten Resonator;

Fig. 2B ein schematisches Diagramm, das den Einfluss einer Verstimmungsschicht mit niedriger akustischer Impedanz beim Trimmen der Resonanzfrequenz eines bekannten Resonators auf die Verstimmung zeigt;

Fig. 2C ein schematisches Diagramm, das den Einfluss einer Verstimmungsschicht mit hoher akustischer Impedanz beim Trimmen der Resonanzfrequenz eines bekannten Resonators auf die Verstimmung zeigt;

Fig. 3 eine schematische Darstellung einer erfindungsgemäßen piezoelektrischen Resonatorvorrichtung;

Fig. 4A eine schematische Darstellung einer piezoelektrischen Resonatorvorrichtung bestehend aus einem verstimmten Resonator gemäß der vorliegenden Erfindung und einem unverstimmten Resonator;

Fig. 4B ein schematisches Diagramm, das den Einfluss der erfindungsgemäßen Verstimmungsschichtfolge beim Trimmen der Resonanzfrequenz des Resonators auf die Verstimmung zeigt;

Fig. 5 eine schematische Darstellung der Anordnung aus Fig. 4A auf einem Substrat mit einem Hohlraum als akustischer Isolator;

Fig. 6 eine schematische Darstellung der Anordnung aus Fig. 4A auf einem Substrat mit einem akustischen Reflektor als akustischer Isolator;

Fig. 7A ein erstes Schaltungsdiagramm eines erfindungsgemäßen Frequenzfilters; und

Fig. 7B ein zweites Schaltungsdiagramm eines erfindungsgemäßen Frequenzfilters.

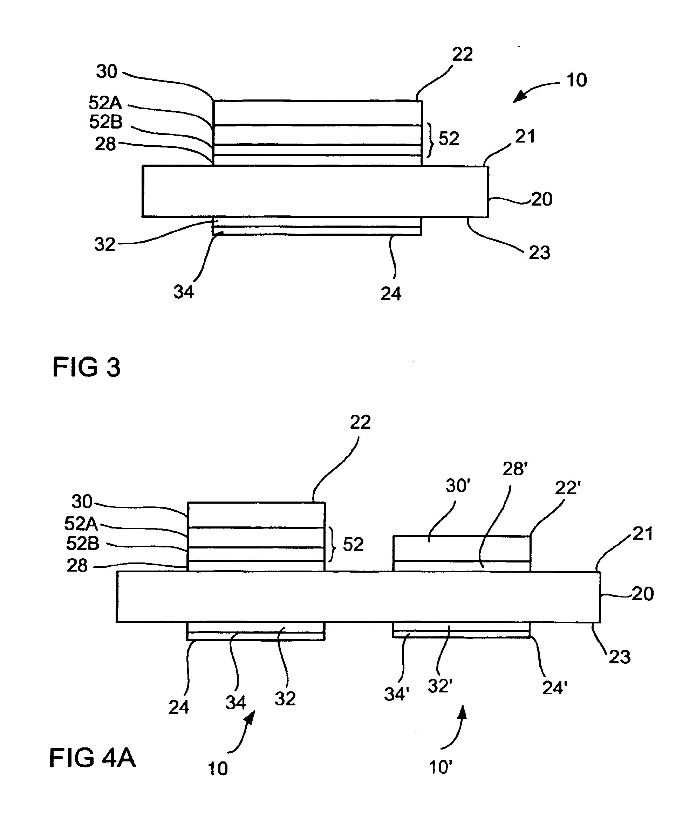

Fig. 3 zeigt eine schematische Schnittdarstellung eines bevorzugten Ausführungsbeispieles einer piezoelektrischen Resonatorvorrichtung gemäß der vorliegenden Erfindung. Elemente, die bereits anhand der vorhergehenden Figuren beschrieben wurden, haben gleiche Bezugszeichen und werden nicht erneut erläutert. Fig. 3 ist eine schematische und nicht maßstäbliche Darstellung. Die Verhältnisse der Schichtdicken der piezoelektrischen Schicht 20 und der Elektroden 22, 24 zueinander und zur lateralen Ausdehnung der Schichten können von dem dargestellten Proportionen abweichen. Die laterale Ausdehnung des eigentlichen piezoelektrischen Resonators 10 ist nur durch die laterale Ausdehnung des Überlappungsbereiches der ersten Elektrode 22 und der zweiten Elektrode 24 definiert. Die erste Elektrode 22 umfasst zwei Schichten 28 und 30, und die zweite Elektrode 24 umfasst zwei Schichten 32 und 34.

Die piezoelektrische Resonatorvorrichtung in Fig. 3 unterscheidet sich von dem in Fig. 2A gezeigten verstimmten Resonator 10 dadurch, dass anstelle der einzelnen Verstimmungsschicht eine Verstimmungsschichtfolge 52 vorgesehen ist, die zwischen der ersten Schicht 28 und der zweiten Schicht 30 der ersten Elektrode 22 angeordnet ist. Die Verstimmungsschichtfolge 52 weist eine erste Schicht 52A und eine zweite Schicht 52B auf. Die erste Schicht 52A der Verstimmungsschichtfolge 52 weist vorzugsweise ein Material mit einer niedrigen akustischen Impedanz, z. B. Al, $SiO_2$ auf. Die zweite Schicht 52B der Verstimmungsschichtfolge 52 weist vorzugsweise ein Material mit einer hohen akustischen Impedanz, z. B. W, Mo, Pt, $Ta_2O_5$ auf. Die Reihenfolge der Schichten 52A, 52B in der Verstimmungsschichtfolge 52 ist beliebig. Vorzugsweise grenzen Schichten der Elektroden und Schichten der Verstimmungsschichtfolge 52, die im wesentlichen gleiche akustische Eigenschaften haben, aneinander.

Die Verstimmungsschichtfolge 52 beeinflusst die Resonanzfrequenz des piezoelektrischen Resonators 10. Sie dient zur Verstimmung des piezoelektrischen Resonators 10, d. h. zur Verschiebung seiner Resonanzfrequenz, gegenüber einem piezoelektrischen Resonator, der keine Verstimmungsschichtfolge 52 und ansonsten die gleichen Eigenschaften aufweist.

Die Herstellung der Verstimmungsschichtfolge 52 erfordert nur einen zusätzlichen Depositions- bzw. Ablagerungsschritt, die Strukturierung kann mit einem einzelnen Lithographie- und Ätz-Schritt erfolgen.

Gegenüber gemäß dem Stand der Technik verstimmten piezoelektrischen Resonatorvorrichtungen weist die piezoelektrische Resonatorvorrichtung gemäß der vorliegenden Erfindung Vorteile beim Trimmen, d. h. beim Feinjustieren der Resonanzfrequenz auf. Das Trimmen des piezoelektrischen Resonators 10 erfolgt durch ein Verändern der Dicke der zweiten Schicht 30 ersten Elektrode 22. Die Veränderung der Dicke der ersten Elektrode 22 erfolgt beispielsweise durch Aufsputtern einer zusätzlichen Schicht des gleichen Materials, oder durch Entfernen einer Teilschicht (Dünnen) der ersten Elektrode 22 durch Ätzen.

Fig. 4A zeigt eine Anordnung ähnlich zu der aus Fig. 2A, wobei hier der verstimmte Resonator die Verstimmungsschichtfolge gemäß der vorliegenden Erfindung aufweist. In Fig. 4A ist ein bevorzugtes Ausführungsbeispiel gezeigt, bei dem die Resonatoren 10, 10' derart verschaltet sind, dass ein Filter gebildet ist. Der unverstimmte Resonator 10' ist seriell zwischen einen Eingang und einen Ausgang geschaltet, und der verstimmte Resonator 10 ist der Nebenschluß-Resonator. Die piezoelektrische Schicht 20 ist aus AlN hergestellt und hat eine Dicke zwischen $2\,\mu m$ und $3\,\mu m$, vorzugsweise $2,4\,\mu m$. Die ersten Schichten 32, 32' der zweiten Elektroden 24, 24' sind aus Wolfram hergestellt und haben eine Dicke von 150nm bis 500nm, vorzugsweise 300nm bis 500nm und gemäß einem bevorzugten Ausführungsbeispiel von 400nm. Die zweiten Schichten 34, 34' der zweiten Elektroden 24, 24' sind aus Aluminium hergestellt und haben eine Dicke von 150nm bis 500nm, vorzugsweise 300nm bis 500nm und gemäß einem bevorzugten Ausführungsbeispiel von 400nm. Die ersten Schichten 28, 28' der ersten Elektroden 22, 22' sind aus Wolfram hergestellt und haben eine Dicke von 50nm bis 300nm, vorzugsweise von 100nm bis 300nm und gemäß einem bevorzugten Ausführungsbeispiel von 220nm. Die zweiten Schichten 30, 30' der ersten Elektroden 22, 22' sind aus Aluminium hergestellt und haben eine Dicke von 250nm bis 700nm, vorzugsweise von 500nm bis 700nm und gemäß einem bevorzugten Ausführungsbeispiel von 660nm. Die erste Verstimmungsschicht 52A ist aus Aluminium hergestellt und hat eine Dicke von 50nm bis 100nm, vorzugsweise von 100nm bis 200nm und gemäß einem bevorzugten Ausführungsbeispiel von 130nm. Die zweite Verstimmungsschicht 52B ist aus Molybdän hergestellt und hat eine Dicke von 10nm bis 60nm, vorzugsweise von 20nm bis 60nm und gemäß einem bevorzugten Ausführungsbeispiel von 40nm. Eine Feineinstellung der Frequenz der Resonatoren 10 und 10' bzw. eine erforderliche Frequenzkorrektur erfolgt durch ein Verändern der Dicke der ersten Elektroden 22, 22' innerhalb gewisser Grenzen. Dazu wird durch ein geeignetes Verfahren Material von der ersten Elektrode 22, 22' abgetragen, so dass deren Dicke lateral gleichmäßig reduziert wird, oder zusätzliches Material auf die erste Elektrode 22, 22' aufgetragen, so dass die Dicke derselben lateral homogen vergrößert wird. Ein Abtragen ist beispielsweise durch einen Ätzprozess möglich, ein Auftragen beispielsweise durch Aufsputtern.

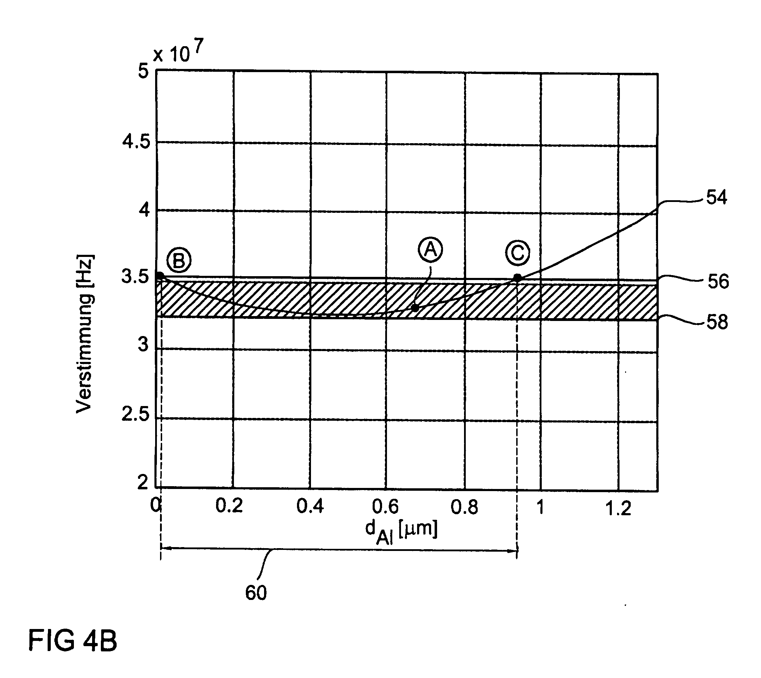

Fig. 4B zeigt für die Anordnung aus Fig. 4A, analog zu den Fig. 2B und 2C, schematisch die Abhängigkeit einer Verstimmung der piezoelektrischen Resonatorvorrichtung gemäß der vorliegenden Erfindung gegenüber einem Resonator ohne Verstimmungsschichtfolge mit sonst gleichen Eigenschaften von der Dicke $d_{Al}$ der Aluminiumschicht 30 der ersten Elektrode 22. Fig. 4B zeigt schematisch die Verstimmung über der Dicke $d_{Al}$ der Aluminiumschicht der ersten Elektrode, wobei die Kurve 54 den Betrag der Verstimmung als Funktion der Dicke $d_{Al}$ bei konstanter Dicke der Verstimmungsschichtfolge 52 wiedergibt. Da die Verstimmungsschichtfolge 52 der erfindungsgemäßen piezoelektrischen Resonatorvorrichtung die erste Schicht 52A mit einer niedrigen Impedanz und die zweite Schicht 52B mit einer hohen Impedanz umfasst, ist die resultierende Abhängigkeit der Verstimmung von der Dicke $d_{Al}$ der ersten Elektrode 22 näherungsweise eine Überlagerung der in Fig. 2B bzw. Fig. 2C dargestellten Abhängigkeiten. Es ergibt sich eine vergleichsweise schwächere Abhängigkeit der Verstimmung der piezoelektrischen Resonatorvorrichtung von der Dicke $d_{Al}$ der ersten Elektrode, d. h. ein wesentlich flacherer Verlauf der Kurve. Bei einer Dicke der Aluminiumschicht um etwa $0,66\,\mu m$ beträgt die Verstimmung etwa 35 MHz, wie durch den Punkt A verdeutlicht ist. Der Einfluss einer Vergrößerung oder Verringerung der Dicke $d_{Al}$ der ersten Elektrode auf die Verstimmung ist wesentlich geringer. Durch die Linien 56 und 58 ist ein noch akzeptabler Toleranzbereich dargestellt, in dem eine Abweichung von der Sollverstimmung, die durch eine zusätzliche Frequenzkorrektur (Trimmen) bewirkt wird, liegen darf. Innerhalb dieses Toleranzbereiches sind die Auswirkungen der Abweichung der Verstimmung von den 35 MHz aufgrund der Frequenzkorrektur auf die Eigenschaften eines Filters, das den so verstimmten Resonator umfasst, noch vernachlässigbar oder zumindest hinnehmbar.

Durch die Schnittpunkte B und C der Kurve 54 mit den Linien 56 bzw. 58 ist ein Dickenbereich 60 festgelegt, innerhalb dessen die Dicke $d_{Al}$ der Aluminiumschicht der ersten Elektrode geändert werden kann. Bedingt durch die geringe Steigung der Kurve 54 ist nun, anders als im Stand der Technik, ein großer Bereich an Dicken von etwas mehr als 0 $\mu$m bis etwa 0,95$\mu$m festgelegt. In diesem Bereich kann die Dicke der Aluminiumschicht der ersten Elektrode geändert werden, ohne dass dies zu einer Veränderung der Verstimmung außerhalb des Toleranzbereiches führen würde.

Nutzt man den in Fig. 4B gezeigten Toleranzbereich voll aus, läuft also entlang der Kurve 54 vom Punkt B über Punkt A zu Punkt C, so ist durch die Änderung der Dicke $d_{Al}$ eine Frequenzkorrektur von -30 MHz bis +60 MHz bei einer Resonanzfrequenz von 900 MHz des Resonators erreichbar. Mit anderen Worten wird eine Verschiebung der Resonanzfrequenz des Resonators 20 um -30 MHz bis + 60 MHz zu einer Änderung der Verstimmung führen, die noch im Toleranzbereich liegt.

Es ist ein wesentliches Merkmal der vorliegenden Erfindung, dass die Verstimmungsschichtfolge 52 mehrere Schichten 52A, 52B umfasst, die unterschiedliche akustische Impedanzen aufweisen. Die Anzahl, die Reihenfolge und die Dicken der einzelnen Schichten 52A, 52B der Verstimmungsschichtfolge 52 sowie der Ort, wo die Verstimmungsschichtfolge angeordnet ist, können jedoch von den Darstellungen in den Fig. 3 und 4A abweichen. Anders als in Fig. 3 und 4A dargestellt kann die Verstimmungsschichtfolge auch zwischen der ersten und der zweiten Schicht der zweiten Elektrode angeordnet sein. Alternativ kann die Verstimmungsschichtfolge auch zwischen der piezoelektrischen Schicht und der ersten Elektrode oder der zweiten Elektrode, oder auf der ersten oder der zweiten Elektrode angeordnet sein. Ferner kann die Verstimmungsschichtfolge 52 mehr als zwei einzelne Schichten 52A, 52B aufweisen. Der Aufbau der Verstimmungsschichtfolge 52, d.h. Anzahl, Materialien, Dicken und Abfolge der einzelnen Schichten sind vorzugsweise so gewählt, dass, ähnlich wie in Fig. 4B dargestellt, eine schwache Abhängigkeit der Verstimmung von der Dicke der ersten Elektrode 22 resultiert.

Die Dicke der verschiedenen Schichten hängt ferner von der verwendeten Frequenzkorrektur ab, entweder Abscheiden von zusätzlichem Material auf die Elektrode oder Dünnen der Elektrode. Optimale Lösungen können z. B. durch eine Simulation unter Verwendung des bekannten Mason Model Ansatzes gefunden werden, der von K. M. Lakin u. a. in IEEE Trans. Microwave Theory Techniques, Band 41, Nr. 12, 1993 beschrieben wird.

Anstelle der oben beschriebenen mehrschichtigen Elektroden mit zwei oder mehr Schichten können auch Elektroden verwendet werden, die nur eine Schicht aufweisen.

Entsprechend der allgemeinen Tendenz in allen Bereichen der Mikroelektronik möglichst viele, auch verschiedene Schaltungselemente einstückig auszuführen bzw. in einem Bauelement zu integrieren, werden für viele Anwendungen mehrere piezoelektrische Resonatoren auf einem Substrat mit denselben Prozessschritten hergestellt. Diese mehreren Resonatoren können untereinander die gleiche oder auch verschiedene Resonanzfrequenzen aufweisen. Die in Fig. 4A dargestellte piezoelektrische Resonatorvorrichtung ist ein Beispiel dafür.

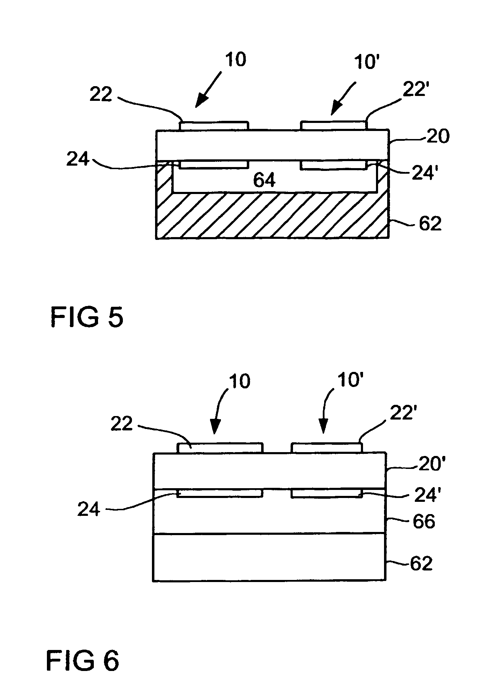

Die erfindungsgemäße Resonatorvorrichtung kann auf unterschiedliche Arten gehalten werden. Gemäß einem Ausführungsbeispiel kann die Resonatorvorrichtung in einem Gehäuse derart getragen sein, dass die Bereiche unter und über den Elektroden frei sind. Herkömmlicherweise ist die Resonatorvorrichtung auf einem Substrat getragen. Um eine Schwingung des Resonators nicht zu beeinflussen ist es erforderlich, denselben von dem Substrat akustisch zu isolieren. Anhand der Fig. 5 und 6 werden zwei Möglichkeiten für die akustische Isolation einer Anordnung gemäß Fig. 4A erläutert, wo bei die Anordnung nur schematisch gezeigt ist.

In Fig. 5 ist die Anordnung aus Fig. 4a auf einem Substrat 62 angeordnet. Das Substrat 62 umfasst zur akustischen Isolation einen Hohlraum 64.

In Fig. 6 ist die Anordnung aus Fig. 4a auf einem Substrat 62 angeordnet. Zwischen der Anordnung und dem Substrat 62 ist zur akustischen Isolation ein durch mehrere Schichten gebildeter akustischer Reflektor 66 angeordnet.

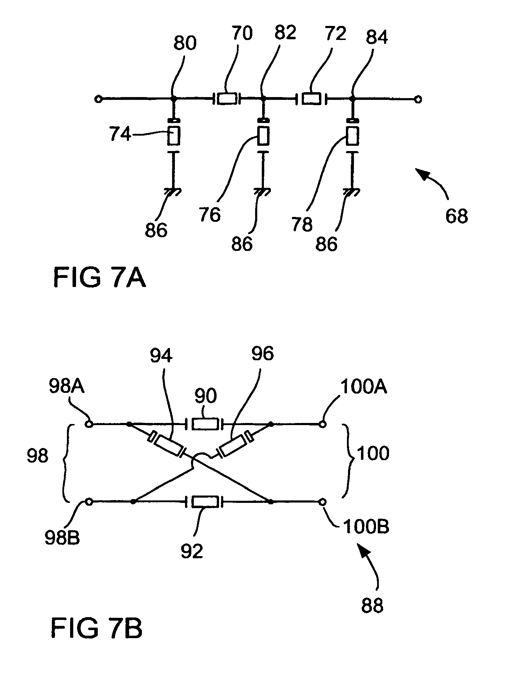

Fig. 7A zeigt schematisch eine unsymmetrische Filterschaltung 68 vom Ladder-Typ mit fünf piezoelektrischen Resonatoren 70, 72, 74, 76, 78. Der erste Resonator 70 ist zwischen einen ersten Knoten 80 und einen zweiten Knoten 82 geschaltet, und der zweite Resonator 72 ist zwischen den zweiten Knoten 82 und einen dritten Knoten 84 geschaltet. Der dritte Resonator 74 ist zwischen den ersten Knoten 80 und ein Bezugspotential 86, z.B. Masse, geschaltet, der vierte Resonator 76 ist zwischen den zweiten Knoten 82 und das Bezugspotential 86 geschaltet, und der fünfte Resonator 78 ist zwischen den dritten Knoten 84 und das Bezugspotential 86 geschaltet. Bei dieser als Frequenzfilter verwendeten, unsymmetrischen Schaltung sind der dritte, vierte und fünfte Resonator 74, 76, 78, die auch als Nebenschluß-Resonatoren bezeichnet werden, gegenüber den zwei in Serie geschalteten Resonatoren 70, 72 um ca. 2% bis 3% in Richtung einer niedrigeren Resonanzfrequenz verstimmt, was vorzugsweise ca. 50% bis 80% der Filter-Bandbreite entspricht. Die Filterschaltung wird durch eine piezoelektrische Resonatorvorrichtung entsprechend der piezoelektrischen Resonatorvorrichtung aus Fig. 4A realisiert, die jedoch zwei unverstimmte piezoelektrische Resonatoren als ersten und zweiten Resonator 70, 72 und ferner drei verstimmte piezoelektrische Resonatoren als dritten, vierten und fünften Resonator 74, 76, 78 aufweist. Durch geeignete Leiterbahnen werden die ersten Elektroden und die zweiten Elektroden der Resonatoren so miteinander verbunden, dass die Filterschaltung entsteht.

Fig. 7B zeigt schematisch eine symmetrische Filterschaltung 88 mit vier piezoelektrischen Resonatoren 90, 92, 94, 96. Die Schaltung umfasst einen Eingang 98 mit Eingangsanschlüssen 98A und 98B und einen Ausgang 100 mit Ausgangsanschlüssen 100A, 100B. Der erste Resonator 90 ist zwischen den Eingangsanschluss 98A und den Ausgangsanschluss 100A geschaltet, der zweite Resonator 92 ist zwischen den Eingangsanschluss 98B und den Ausgangsanschluss 100B geschaltet, der dritte Resonator 94 ist zwischen den Eingangsanschluss 98A und den Ausgangsanschluss 100B geschaltet, und der vierte Resonator 96 ist zwischen den Eingangsanschluss 98B und den Ausgangsanschluss 100A geschaltet. Die Resonatoren 94 und 96 sind gegenüber den Resonatoren 90 und 92 um ca. 2% bis 3% in Richtung einer niedrigeren Resonanzfrequenz verstimmt, was vorzugsweise ca. 50% bis 80% der Filter-Bandbreite entspricht. Die Filterschaltung wird durch eine piezoelektrische Resonatorvorrichtung entsprechend der piezoelektrischen Resonatorvorrichtung aus Fig. 4A realisiert, die jedoch zwei unverstimmte piezoelektrische Resonatoren als ersten und zweiten Resonator 90, 92 und ferner zwei verstimmte piezoelektrische Resonatoren als dritten und vierten Resonator 94, 96 aufweist. Durch geeignete Leiterbahnen werden die ersten Elektroden und die zweiten Elektroden der Resonatoren so miteinander verbunden, dass die Filterschaltung entsteht.

Alternativ können die in Fig. 7A und 7B gezeigten Filter durch herkömmliche Resonatorvorrichtungen, die anhand der Fig. 1 beschrieben wurden, und Resonatorvorrichtungen, die anhand der Figur 3 beschrieben wurden, gebildet sein.

Anstelle der oben beschriebenen Verfahren zum Verändern der Resonanzfrequenz des Resonators durch Ändern der Dicke der oberen Elektrode, können auch andere, im Stand der Technik bekannte Verfahren zum Verändern der Resonanzfrequenz herangezogen werden.

Wie oben beschrieben wurde kann die Verstimmungsschichtfolge gemäß der vorliegenden Erfindung entweder auf der oberen Elektrode angeordnet sein, die im Zuge der Frequenzeinstellung getrimmt wird. Alternativ kann die Verstimmungsschichtfolge auf der unteren Elektrode, die bei einer Frequenzeinstellung (Trimmen) nicht beeinflusst wird, angeordnet sein.

Der piezoelektrische Resonator ist bei den beschriebenen Ausführungsbeispielen durch ein piezoelektrische Schicht gebildet. Anstelle dieser Ausgestaltung kann der piezoelektrische Resonator auch eine Mehrzahl von piezoelektrischen Schichten umfassen.

Bezugszeichenliste

| | |
|---|---|
| 10 | piezoelektrischer Resonator |
| 10' | verstimmter piezoelektrischer Resonator |
| 20 | piezoelektrische Schicht |
| 21 | erste Oberfläche |
| 22, 22' | erste Elektrode |
| 23 | zweite Oberfläche |
| 24, 24' | zweite Elektrode |
| 26 | Verstimmungsschicht |
| 28, 28' | erste Schicht der ersten Elektrode |
| 30, 30' | zweite Schicht der ersten Elektrode |
| 32, 32' | erste Schicht der zweiten Elektrode |
| 34, 34' | zweite Schicht der zweiten Elektrode |
| 36 | Kurve |
| 38,40 | Toleranzbereich |
| 42 | Dickenbereich |
| 44 | Kurve |
| 46,48 | Toleranzbereich |
| 50 | Dickenbereich |
| 52 | Verstimmungsschicht |
| 52A | erste Schicht mit niedriger akustischer Impedanz |
| 52B | zweite Schicht mit hoher akustischer Impedanz |
| 54 | Kurve |
| 56,58 | Toleranzbereich |
| 60 | Dickenbereich |
| 62 | Substrat |
| 64 | Hohlraum |
| 66 | akustischer Reflektor |
| 68 | Filter |
| 70 bis 78 | Resonatoren |
| 80 bis 84 | Knoten |
| 86 | Bezugspotential |
| 88 | Filter |
| 90 bis 96 | Resonatoren |
| 98 | Eingang |
| 98A, 98B | Eingangsanschluß |
| 100 | Ausgang |
| 100A, 100B | Ausgangsanschluß |

**Patentansprüche**

1. Resonatorvorrichtung mit
einem ersten piezoelektrischen Resonator (10) und einem zweiten piezoelektrischen Resonator (10'), wobei der erste piezoelektrische Resonator (10) und der zweite piezoelektrische resonator (10') jeweils eine piezoelektrische Schicht (20) mit einer ersten Oberfläche (21) und einer zweiten Oberfläche (23), eine erste Elektrode (22, 22') an der ersten Oberfläche (21) und eine zweite Elektrode (24, 24') an der zweiten Oberfläche (23) aufweisen; und
einer Verstimmungsschichtfolge (52), die an dem ersten piezoelektrischen Resonator (10) angeordnet ist;

**dadurch gekennzeichnet, dass**

die Verstimmungsschichtfolge (52) auf der ersten Elektrode (22) des ersten piezoelektrischen Resonators (10) oder auf der zweiten Elektrode (24) des ersten piezoelektrischen Resonators (10) angeordnet ist; und

die Verstimmungsschichtfolge (52) zumindest eine erste Schicht (52A) mit einer ersten akustischen Impedanz und eine zweite Schicht (52B) mit einer zweiten akustischen Impedanz aufweist, um eine Resonanzfrequenz des ersten piezoelektrischen Resonators (10) gegenüber der Resonanzfrequenz des zweiten piezoelektrischen Resonators (10') zu verschieben, wobei die erste akustische Impedanz niedriger ist als die zweite akustische Impedanz.

2. Resonatorvorrichtung gemäß Anspruch 1, bei der sich die akustischen Impedanzen der Schichten (52A, 52B) der Verstimmungsschichtfolge (52) um den Faktor zwei voneinander unterscheiden.

3. Resonatorvorrichtung gemäß Anspruch 1 oder 2, bei der die Impedanz der Schicht mit hoher akustischer Impedanz zwischen $60 \times 10^6 \ \dfrac{kg}{s \cdot m^2}$ und $100 \times 10^6 \ \dfrac{kg}{s \cdot m^2}$ ist, und bei der die Impedanz der Schicht mit niedriger akustischer Impedanz zwischen $10 \times 10^6 \ \dfrac{kg}{s \cdot m^2}$ und $30 \times 10^6 \ \dfrac{kg}{s \cdot m^2}$ ist.

4. Resonatorvorrichtung gemäß einem der Ansprüche 1 bis 3, bei der die Schicht (52A) mit der niedrigen akustischen Impedanz Al oder $SiO_2$ aufweist.

5. Resonatorvorrichtung gemäß einem der Ansprüche 1 bis 4, bei der die Schicht (52B) mit der hohen akustischen Impedanz W, Mo, Pt oder $Ta_2O_5$ aufweist.

6. Resonatorvorrichtung gemäß einem der Ansprüche 1 bis 5, bei der die erste Schicht (52A) mit der niedrigen akustischen Impedanz eine Dicke im Bereich von 50nm bis 200nm aufweist, und bei der die zweite Schicht (52B) mit der hohen akustischen Impedanz eine Dicke im Bereich von 10nm bis 60nm aufweist.

7. Resonatorvorrichtung gemäß einem der Ansprüche 1 bis 6 mit einem Substrat (62), auf dem der erste und der zweite piezoelektrische Resonators (10, 10') akustisch isoliert angeordnet sind.

8. Resonatorvorrichtung gemäß Anspruch 7 bei dem ein Hohlraum (64) oder ein akustischer Reflektor (66) zwischen dem ersten piezoelektrischen Resonator (10) und dem Substrat (62) und zwischen dem zweiten piezoelektrischen Resonator (10') und dem Substrat (62) zur akustischen Isolation angeordnet ist.

9. Resonatorvorrichtung gemäß einem der Ansprüche 1 bis 8 bei der sich die Resonanzfrequenzen des piezoelektrischen Resonators (10) und des zweiten piezoelektrischen Resonators (10') um 2% bis 3% unterscheiden.

10. Resonatorvorrichtung gemäß einem der Ansprüche 1 bis 9, bei der der zweite piezoelektrische Resonator (10') zwischen einen ersten Knoten und einen zweiten Knoten geschaltet ist, und bei der der erste piezoelektrische Resonator (10) zwischen den zweiten Knoten und ein Bezugspotential geschaltet ist.

11. Resonatorvorrichtung gemäß einem der Ansprüche 1 bis 10, bei der der erste und der zweite piezoelektrische Resonator (10, 10') eine Mehrzahl von piezoelektrischen Schichten umfassen.

12. Filter (68, 88) mit einer Resonatorvorrichtung gemäß einem der Ansprüche 1 bis 11.

**Claims**

1. Resonator device with

a first piezoelectric resonator (10) and a second piezoelectric resonator (10'), wherein the first piezoelectric resonator (10) and the second piezoelectric resonator (10') each comprise a piezoelectric layer (20) with a first surface (21) and a second surface (23), a first electrode (22, 22') at the first surface (21) and a second electrode (24, 24') at the second surface (23); and

a detuning layer sequence (52) arranged at the first piezoelectric resonator (10);

**characterized in that**

the detuning layer sequence (52) is arranged at the first electrode (22) of the first piezoelectric resonator (10) or at the second electrode (24) of the first piezoelectric resonator (10); and

the detuning layer sequence (52) comprises at least a first layer (52A) with a first acoustic impedance and a second layer (52B) with a second acoustic impedance to shift the resonance frequency of the first piezoelectric resonator (10) compared to the resonance frequency of the second piezoelectric resonator (10'), wherein the first acoustic impedance is lower than the second acoustic impedance.

**2.** Resonator device according to claim 1, wherein the acoustic impedances of the layers (52A, 52B) of the detuning layer sequence (52) differ by a factor of two.

**3.** Resonator device according to claim 1 or 2, wherein the impedance of the layer with high acoustic impedance is between $60 \times 10^6$ (kg)/(s•m²) and $100 \times 10^6$ (kg)/(s•m²), and wherein the impedance of the layer with low acoustic impedance is between $10 \times 10^6$ (kg)/(s•m²) and $30 \times 10^6$ (kg)/(s•m²).

**4.** Resonator device according to one of the claims 1 to 3, wherein the layer (52A) with the low acoustic impedance comprises Al or $SiO_2$.

**5.** Resonator device according to one of the claims 1 to 4, wherein the layer (52B) with the high acoustic impedance comprises W, Mo, Pt or $Ta_2O_5$.

**6.** Resonator device according to one of the claims 1 to 5, wherein the first layer (52A) with the low acoustic impedance has a thickness in the range of 50nm to 200nm, and wherein the second layer (52B) with the high acoustic impedance has a thickness in the range of 10nm to 60nm.

**7.** Resonator device according to one of the claims 1 to 6 with a substrate (62), on which the first and the second piezoelectric resonator (10, 10') are arranged acoustically insulated.

**8.** Resonator device according to claim 7, wherein a cavity (64) or an acoustic reflector (66) is arranged for acoustic insulation between the first piezoelectric resonator (10) and the substrate (62) and between the second piezoelectric resonator (10') and the substrate (62).

**9.** Resonator device according to one of the claims 1 to 8, wherein the resonance frequencies of the piezoelectric resonator (10) and the second piezoelectric resonator (10') differ by 2% to 3%.

**10.** Resonator device according to one of the claims 1 to 9, wherein the second piezoelectric resonator (10') is connected between a first node and a second node, and wherein the first piezoelectric resonator (10) is connected between the second node and a reference potential.

**11.** Resonator device according to one of the claims 1 to 10, wherein the first and the second resonator (10, 10') comprise a plurality of piezoelectric layers.

**12.** Filter (68, 88) with a resonator device according to one of the claims 1 to 11.

**Revendications**

**1.** Dispositif à résonateur comprenant
un premier résonateur piézo-électrique (10) et un second résonateur piézo-électrique (10'), le premier résonateur piézo-électrique (10) et le second résonateur piézo-électrique (10') comprenant respectivement une couche piézo-électrique (20) dotée d'une première surface (21) et d'une seconde surface (23), une première électrode (22, 22') sur la première surface (21) et une seconde électrode (24, 24') sur la seconde surface (23) ; et
une série de couches de désaccord (52), qui est disposée sur le premier résonateur piézo-électrique (10) ;
**caractérisé en ce que**
la série de couches de désaccord (52) est disposée sur la première électrode (22) du premier résonateur piézoélectrique (10) ou sur la seconde électrode (24) du premier résonateur piézoélectrique (10) ; et
la série de couches de désaccord (52) comprend au moins une première couche (52A) dotée d'une première impédance acoustique et une seconde couche (52B) dotée d'une seconde impédance acoustique, afin de déplacer une fréquence de résonance du premier résonateur piézoélectrique (10) par rapport à la fréquence de résonance du second résonateur piézoélectrique (10'), la première impédance acoustique étant inférieure à la seconde impédance acoustique.

**2.** Dispositif à résonateur selon la revendication 1, dans lequel les impédances acoustiques des couches (52A, 52B) de la série de couches de désaccord (52) se différencient l'une de l'autre du facteur deux.

**3.** Dispositif à résonateur selon la revendication 1 ou 2, dans lequel l'impédance de la couche présentant une impédance acoustique élevée est comprise entre $60x10^6 \frac{kg}{s \cdot m^2}$ et $100x10^6 \frac{kg}{s \cdot m^2}$, et dans lequel l'impédance de la couche présentant une impédance acoustique peu élevée est comprise entre $10x10^6 \frac{kg}{s \cdot m^2}$ et $30x10^6 \frac{kg}{s \cdot m^2}$.

**4.** Dispositif à résonateur selon l'une quelconque des revendications 1 à 3, dans lequel la couche (52A) présentant l'impédance acoustique peu élevée comprend de Al ou du $SiO_2$.

**5.** Dispositif à résonateur selon l'une quelconque des revendications 1 à 4, dans lequel la couche (52B) présentant l'impédance acoustique élevée comprend du W, Mo, Pt ou $Ta_2O_5$.

**6.** Dispositif à résonateur selon l'une quelconque des revendications 1 à 5, dans lequel la première couche (52A) présentant l'impédance acoustique peu élevée comprend une épaisseur dans la plage de 50 nm à 200 nm, et dans lequel la seconde couche (52B) présentant l'impédance acoustique élevée comprend une épaisseur dans la plage de 10 nm à 60 nm.

**7.** Dispositif à résonateur selon l'une quelconque des revendications 1 à 6 comprenant un substrat (62), sur lequel les premier et second résonateurs piézoélectriques (10, 10') sont disposés avec une isolation acoustique.

**8.** Dispositif à résonateur selon la revendication 7 dans lequel une cavité (64) ou un réflecteur acoustique (66) est disposé(e) entre le premier résonateur piézoélectrique (10) et le substrat (62) et entre le second résonateur piézoélectrique (10') et le substrat (62) en vue de l'isolation acoustique.

**9.** Dispositif à résonateur selon l'une quelconque des revendications 1 à 8 dans lequel les fréquences de résonance du résonateur piézoélectrique (10) et du second résonateur piézoélectrique (10') se différencient de 2 à 3%.

**10.** Dispositif à résonateur selon l'une quelconque des revendications 1 à 9, dans lequel le second résonateur piézoélectrique (10') est monté entre un premier noeud et un second noeud, et dans lequel le premier résonateur piézoélectrique (10) est monté entre le second noeud et un potentiel de référence.

**11.** Dispositif à résonateur selon l'une quelconque des revendications 1 à 10, dans lequel les premier et second résonateurs piézoélectriques (10, 10') comportent une pluralité de couches piézo-électriques.

**12.** Filtre (6,8, 88) comprenant un dispositif à résonateur selon l'une quelconque des revendications 1 à 11.

FIG 1A

FIG 1B

FIG 2A

FIG 2B

EP 1 393 440 B1

FIG 2C

EP 1 393 440 B1

FIG 3

FIG 4A

EP 1 393 440 B1

FIG 4B

FIG 5

FIG 6

FIG 7A

FIG 7B

**EP 1 393 440 B1**

## IN DER BESCHREIBUNG AUFGEFÜHRTE DOKUMENTE

**In der Beschreibung aufgeführte Patentdokumente**

- WO 9910938 A

- US 5894647 A

**In der Beschreibung aufgeführte Nicht-Patentliteratur**

- **K. M. Lakin.** *IEEE Trans. Microwave Theory Techniques,* 1993, vol. 41 (12